# EUROPEAN PATENT SPECIFICATION

(11) **EP 0 280 575 B1**
(45) Date of publication and mention of the grant of the patent: **14.09.1994**
(21) Application number: 88301702.2
(22) Date of filing: 26.02.1988
(51) Int. Cl.: H03H 17/06, G11B 20/10, H03H 17/04, G11B 20/00

(54) **Fir type digital filter for recording and reproducing apparatus**
Digitaler FIR-Filter für Aufzeichnungs- und Wiedergabegerät
Filtre digital du type RIF pour appareil d'enregistrement et de reproduction

(30) Priority: 26.02.1987 JP 43808/87; 21.08.1987 JP 207860/87
(43) Date of publication of application: 31.08.1988
(73) Proprietor: SONY CORPORATION, Tokyo 141 (JP)
(72) Inventor: Yamada, Makoto, Shinagawa-ku Tokyo (JP); Odaka Kentaro, Shinagawa-ku Tokyo (JP)
(74) Representative: Ayers, Martyn Lewis Stanley

(56) References cited:
- EP-A- 0 155 101
- EP-A- 0 173 307
- FR-A- 2 566 604
- PATENT ABSTRACTS OF JAPAN vol. 10, no. 104 (E-397)(2161) 19 April 1986,& JP-A-60 242717 (SONY K.K.) 2 December 1985,

## Description

The present invention relates to a digital filter and, more particularly, to a digital filter used for a digital recording/reproducing apparatus.

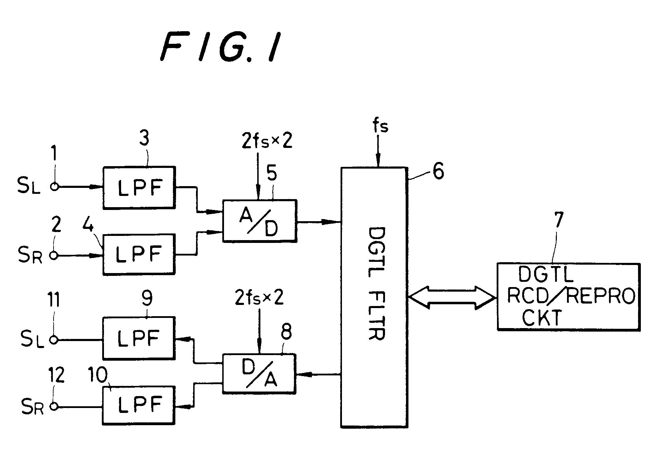

Recently, a digital recording/reproducing apparatus known as a digital audio tape (DAT) recorder has been developed. In such an apparatus, as shown in fig 1 of the accompanying drawings, in a recording mode, L- and R-channel analog audio signals S_{L} and S_{R} respectively supplied to input terminals 1 and 2 are converted into digital audio signals by a common A/D converter 5 respectively through low-pass filters 3 and 4. In this case, in the A/D converter, oversampling is performed at a frequency 2fₛ, ie, twice a normal sampling frequency fₛ. In the oversampling, the signals S_{L} and S_{R} are alternately sampled in the order of S_{L}, S_{R}, S, S_{R}, ..., starting from SL. Therefore, in order to obtain a sampling rate of 2fₛ for each of the two-channel signals, a sampling clock of a frequency of 2fₛ x 2 is supplied to the A/D converter 5.

The 2-channel digital signals obtained from the A/D converter 5 are supplied to a digital low-pass filter (to be referred to "digital filter" hereinafter) 6. In the digital filter 6, the sampling rate of 2fₛ is converted to a normal sampling rate of fₛ. Thereafter, the digital signals are supplied to a digital recording and reproducing circuit 7, and are recorded on a magnetic tape.

During reproduction, the L- and R-channel digital signals reproduced from the magnetic tape are respectively supplied from the recording and reproducing circuit 7 to the digital filter 6, and are sampled at the sampling rate fₛ. Thereafter, the digital signals are supplied to a common D/A converter 8. Sampling is started from the L channel at the sampling rate of 2fₛ, and the digital signals are alternately oversampled in the order L, R, L, R, ..., to be converted to analog signals. The analog signals are derived from output terminals 11 and 12 as reproduced original signals S_{L} and S_{R} through low-pass filters 9 and 10.

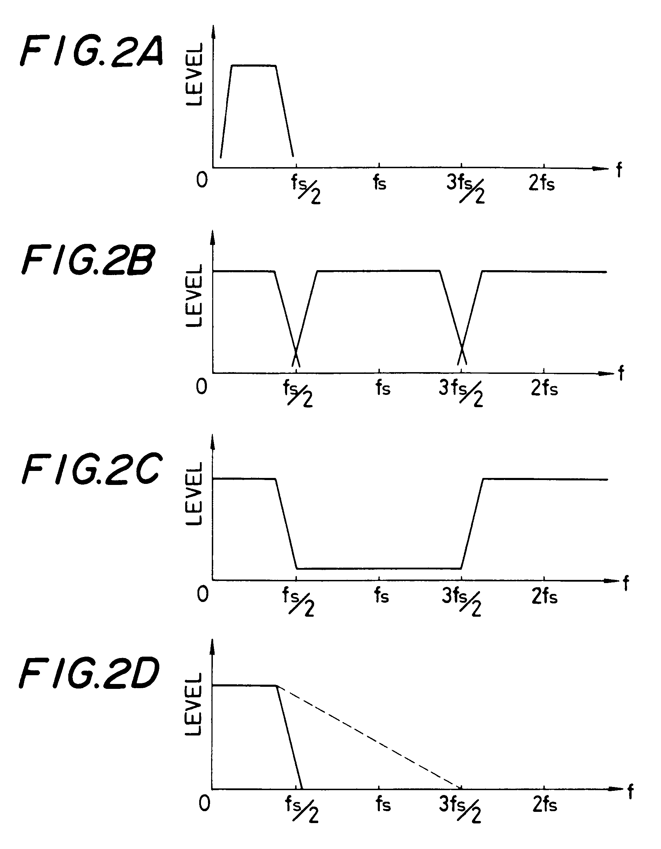

The oversampling is performed by the A/D converter 5 in the recording mode and by the D/A converter 8 in the reproducing mode, so that design of the low-pass filters 3, 4, 9 and 10 can be facilitated. That is, assuming that the analog audio signals S_{L} and S_{R} have a bandwidth of about 0 to fₛ/2, as shown in fig 2A, recording and reproducing signals to and from the recording and reproducing circuit 7 have attenuation characteristics near fₛ/2 and 3fₛ/2, as shown in fig 2B.

As the digital filter 6, a filter having filter characteristics for attenuating an input within the range of fₛ/2 to 3fₛ/2, as shown in fig 2C, is employed. Therefore, the low-pass filters 3, 4, 9 and 10 can allow a signal with the spectrum shown in fig 2A to pass therethrough and can remove a signal of 3fₛ/2 or higher as in fig 2C. For example, the filters can have a moderate attenuation characteristic curve as indicated by the dotted line in fig 2D. With this arrangement, design of the low-pass filters 3, 4, 9 and 10 can be facilitated, thus providing practice advantages in respect of signal distortion and cost. In the above case, the oversampling frequency is set to twice the normal frequency fₛ. If the magnification of the oversampling rate is further increased, the inclination of the characteristic curve of the low-pass filter can be further decreased.

In the above-mentioned digital recording/reproducing apparatus, it is preferable that L- and R-channel signals are alternately recorded on the magnetic tape without any phase difference therebetween.

In the circuit shown in fig 1, in the recording mode, the signals S_{L} and S_{R} passing through the low-pass filters 3 and 4 are alternately sampled in the order L, R, ..., from the L channel by the A/D converter 5, and are supplied to the digital filter 6. In this digital filter 6, L- and R-channel signal processing operations are started at the same time. For this reason, the L-channel signal output from the digital filter 6 is phase-delayed from the R-channel signal output therefrom, and these signals are recorded on the magnetic tape with a phase difference.

In the reproducing mode, the 2-channel signals which are recorded on the magnetic tape with no phase difference are reproduced, and are simultaneously subjected to signal processing by the digital filter 6. Thereafter, these signals are alternately sampled by the D/A converter 8 in the order of L, R, ..., from the L channel. As a result, the L-channel signal output from the D/A converter 8 is phase-advanced from the R-channel signal. The 2-channel reproduced signals supplied to 2-channel loudspeakers, thus have a phase difference therebetween impairing stability and the stereophonic effect of the sound.

In order to solve the above problems, two A/D and D/A converters can be provided for each of the 2-channel, ie, L- and R-channel signals. However, the resulting circuit arrangement is complicated and cost is increased.

Japanese Patent Laid-Open (Kokai) No 60-242717 discloses a technique for reproducing signals while matching L- and R-channel phases. However, this patent does not describe a recording/reproducing apparatus at all. According to the present invention, there is provided a digital filter for a recording/reproducing apparatus comprising:
a single analog-to-digital converter and/or a single digital-to-analog converter for 2-channel signals; and
means for storing first and second multiplication coefficient groups providing predetermined filter characteristics and in interpolation relationship with each other, characterised in that the filter is operative such that
in a recording mode, the first multiplication coefficient group is used for the first channel signal, and the second multiplication coefficient group is used for the second channel signal, and
in a reproducing mode, the second multiplication coefficient group is used for the first channel signal, and the first multiplication coefficient group is used for the second channel signal.

As will become apparent from the following description, the present invention can provide a digital filter which can obtain 2-channel signals without a phase difference in a recording/reproducing mode. The illustrated digital filter changes the magnification of oversampling with respect to a single-channel signal using the same circuit arrangement as that of a circuit for processing 2-channel signals and removes the phase difference between 2-channel signals in recording and reproducing modes such that multiplication coefficient groups for defining filter characteristics of a digital filter are switched in accordance with L-/R-channel signals.

The invention will be further described by way of non-limitative example with reference to the accompanying drawings, in which:-
Fig 1 is a block diagram showing a prior art circuit;
Figs 2A to 2D are graphs showing characteristics of the circuit shown in fig 1;
Fig 3 is a block diagram schematically showing a digital filter when 2-channel signals are recorded/reproduced;
Fig 4 is a graph showing impulse response characteristics of a digital filter;
Fig 5 is a graph showing impulse response characteristics for L- and R-channels in the recording mode;
Fig 6 is a graph showing impulse response characteristics for L- and R-channels in the reproducing mode;
Figs 7A and 7B are graphs showing filter characteristics when four-times oversampling is performed; and
Fig 8 is a block diagram showing an embodiment of the present invention.

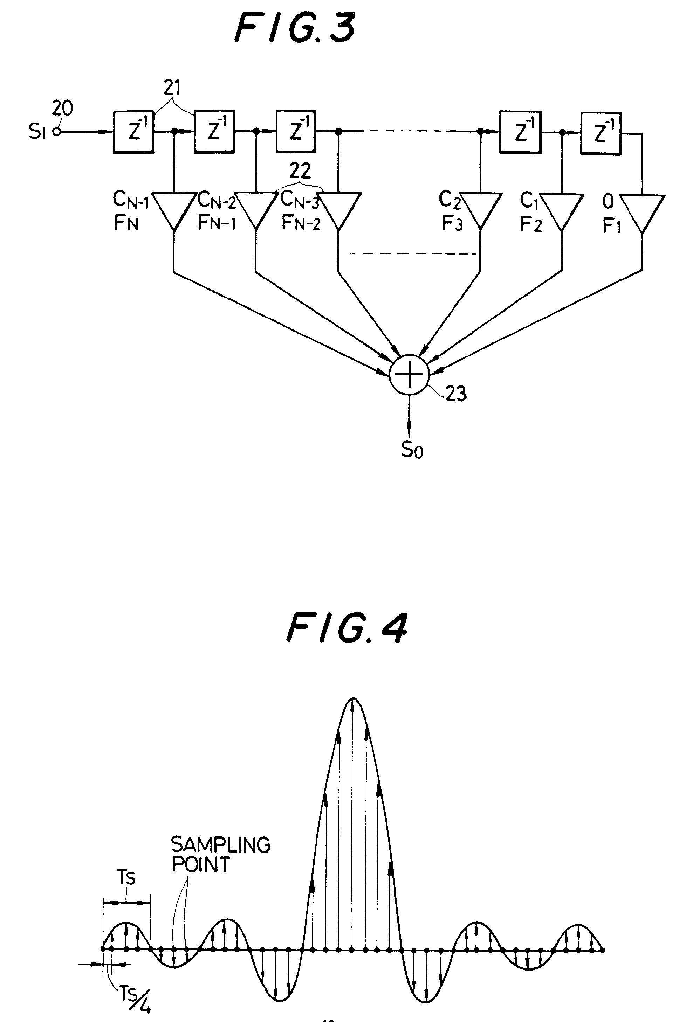

Fig 3 schematically shows a FIR type digital filter used for recording/reproducing 2-channel signals. An L- or R-channel input digital signal S_{I} supplied to an input terminal 20 sequentially passes through a series of N delay elements 21. The delay time of each delay element 21 is set to be one sampling period 1/2fₛ when double-rate oversampling is performed.

Outputs from the delay elements 21 are multiplied and weighted with a predetermined multiplication coefficient by corresponding coefficient devices 22, and are summed by an adder 23, thus outputting an output signal S_{O}. The output signal S_{O} has predetermined filter characteristics shown in fig 2C with respect to the input signal S_{I}. The coefficient devices 22 have two groups of multiplication coefficients, ie, a C coefficient group of O, C₁, C₂, ..., C_{N-2}, C_{N-1}, and an F coefficient group of F₁, F₂, ..., F_{N}. The coefficient devices 22 select and use one of the first and second multiplication coefficient groups.

In this embodiment, in the recording mode of 2-channel signals, if the input signal S_{I} is an L-channel signal, the C coefficient group is used. If the input signal S_{I} is an R-channel signal, the F coefficient group is used. In the reproducing mode of the 2-channel signals, if the input signal S_{I} is the L-channel signal, the F coefficient group is used, and if the input signal S_{I} is the R-channel signal, the C coefficient group is used.

Fig 4 shows an example of the impulse response characteristics of the digital filter of figure 3.

The response characteristics represent a change in time of the output signal S_{O} when an impulse is applied to the input terminal 20. More specifically, the impulse is sequentially delayed by the delay elements 21, and the respective delayed outputs are weighted by the corresponding coefficient devices 22. Thereafter these outputs are sequentially output through the adder 23.

In this impulse response characteristics, the interval between sampling points (output timings of the delay elements 21) is TS/4 (1/4fₛ). The length of the arrow at each sampling point corresponds to an impulse having a size corresponding to the coefficient of each coefficient device 22. The coefficients of the coefficient devices 22 are selected as described above, so that the filter characteristics in the case of double or four-time oversampling rate shown in fig 2C described above or in fig 7A to be described later can be obtained.

As described above, in the 2-channel signal recording mode, the digital filter 6 simultaneously starts signal processing of signals supplied from the A/D converter 5 shown in fig 1 in the order L, R, L, R, .... Therefore, the L-channel signal output from the digital filter 6 is delayed relative to the R-channel signal output. The delay is Ts/4 with respect to 1/2 of a sampling period 2fₛ, ie, a normal sampling period Tₛ (= 1/fₛ). Therefore, the digital filter 6 can perform correction such that the R-channel signal is delayed by Tₛ/4 with respect to the L-channel signal. For this purpose, the curve of the impulse response characteristics of the R-channel digital filter 6 can be delayed by Tₛ/4 from the curve of the response characteristics of the L-channel digital filter 6.

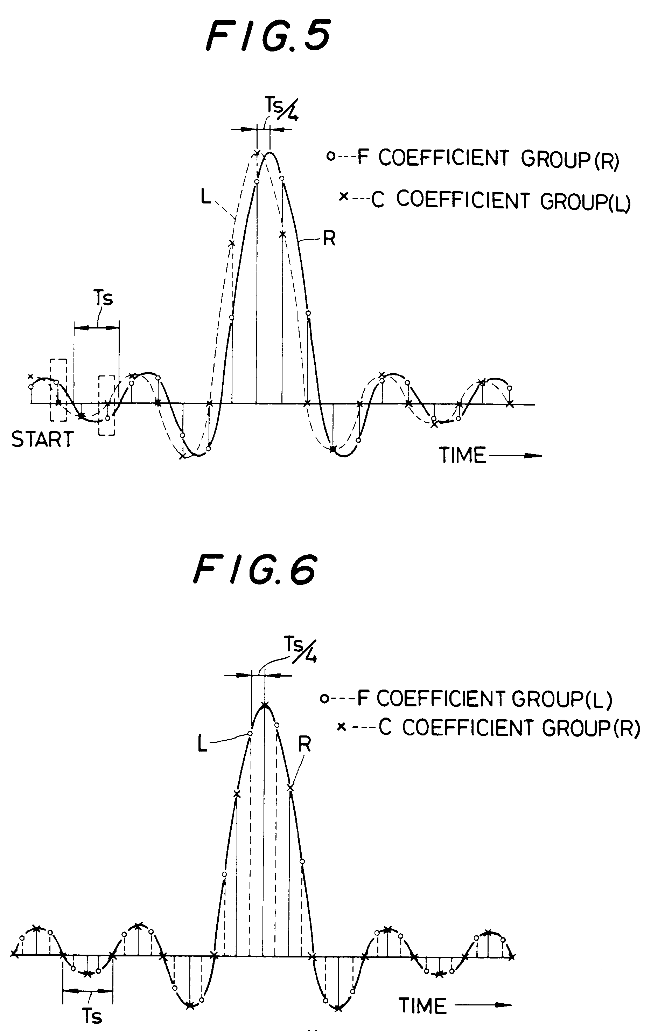

Fig 5 shows the impulse response characteristics of the digital filter in a digital signal recording mode based on the above principle. The solid curve R indicated by "o" points represents the characteristics of the R-channel digital filter, and the dotted curve L indicated by "x" points represents characteristics of the L-channel digital filter. The curve R is delayed by Tₛ/4 relative to the curve L. The size (height) of an impulse from a reference level indicated by "o" and "x" is determined such that "o" is determined by the F coefficient group and "x" is determined by the C coefficient group. The coefficients of the C and F coefficient groups are alternately set in fig 4. In this invention, every other sampling point in fig 4 are selected to be classified into the C and F coefficient groups, and these coefficient groups are respectively used for the L- and R-channels. Therefore, the coefficients of the C and F coefficient groups in fig 5 are set to interpolate with each other with respect to the overall characteristics of the digital filter shown in fig 4. Note that signal processing is simultaneously started for the L-and R-channel signals. In order to convert the sampling rate 2fₛ from the A/D converter 5 into a sampling rate fₛ, every other data sample enclosed shown by dotted lines is not output in practice. In fig 5, two sets of data are enclosed in the dotted lines.

In the reproducing mode of the 2-channel signals recorded as described above, the 2-channel signals which are recorded on the magnetic tape without a phase difference are simultaneously subjected to signal processing by the digital filter 6 and are alternately sampled by the D/A converter 8 in the order of the L, R, .... In this case, the R-channel signal output from the D/A converter 8 is delayed from the L-channel signal by Tₛ/4. Therefore, the digital filter 6 can perform correction such that the L-channel signal is delayed by Tₛ/4. Therefore, the digital filter 6 can perform correction such that the L-channel signal is delayed by Tₛ/4 from the R-channel signal. For this purpose, the curve of the impulse response characteristics of the L-channel digital filter 6 can be delayed by Tₛ/4 relative to the curve of the impulse response characteristics of the R-channel digital filter 6.

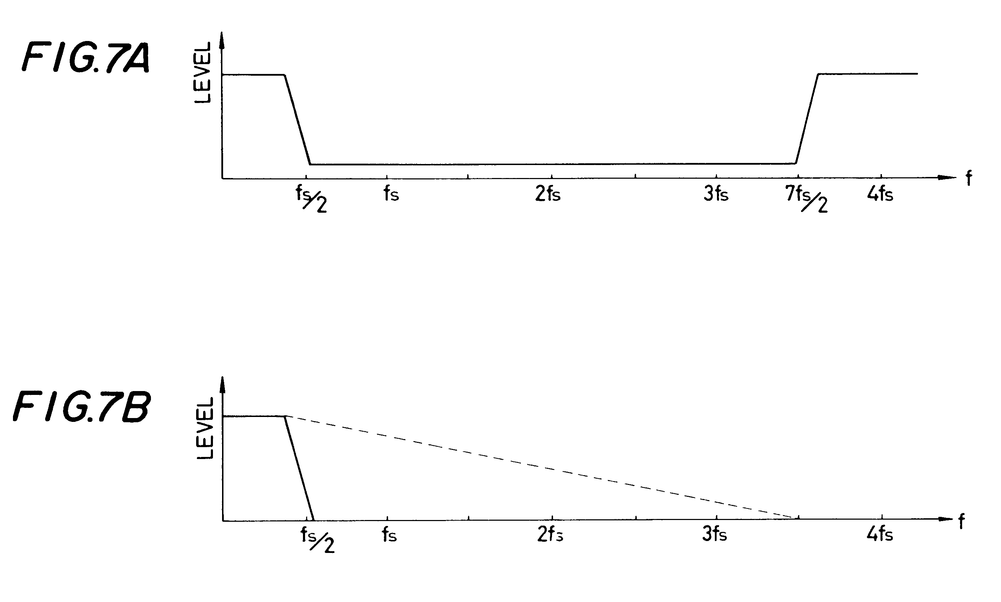

Fig 6 shows impulse response characteristics of the digital filter in a 2-channel signal reproducing mode based on the above principle. The curve L indicated by "o" points represents characteristics of the L-channel digital filter, and the curve R indicated by "x" points represents characteristics of the R-channel digital filter. The curve L is delayed by Tₓ/4 relative to the curve R. The size (height) of an impulse from a reference level indicated by "o" and "x" is determined such that "o" is determined by the F coefficient group and "x" is determined by the C coefficient group. The coefficients of the C and F coefficient groups are set to interpolate with each other to provide the overall characteristics of the digital filter shown in fig 4. In order to convert a signal of the sampling rate fₛ from the digital filter 6 into a signal having sampling rate twice fₛ, ie, 2fₛ by the D/A converter 8, the recording and reproducing circuit 7 inserts zero data as every other data sample and supplies the data sample to the digital filter 6 in practice.

A case will be described wherein a single-channel signal is recorded/reproduced.

In fig 1, the terminal 1 and the low-pass filter 3 or the terminal 2 and the low-pass filter 4 are omitted, and the terminal 11 and the low-pass filter 9 or the terminal 12 and the low-pass filter 10 are omitted. In addition, a single-channel input signal such as a monaural audio signal is supplied to the terminal 1 or 2, and a monaural reproduced analog audio signal is derived from the terminal 11 or 12. This case will be described below.

In the recording mode, a signal obtained from the low-pass filter 3 or 4 is converted by the A/D converter 5 to have a sampling rate 4fₛ. A signal which is oversampled at a four-times sampling rate is converted by the digital filter 6 to have a sampling rate fₛ, and is then supplied to the recording and reproducing circuit 7. Note that in order to convert the sampling rate 4fₛ into fₛ, every fourth data sample is output.

In the reproducing mode, the signal reproduced by the recording and reproducing circuit 7 is supplied to the D/A converter 8 through the digital filter 6, and is converted from fₛ to a sampling rate 4fₛ. Thereafter, the signal is supplied to the low-pass filter 9 or 10. Note that in order to convert a signal of a sampling rate fₛ from the digital filter 6 into a signal of a sampling rate of 4fₛ by the D/A converter 8, the recording and reproducing circuit 7 outputs the data sample at every fourth sampling point and inserts zero data samples therebetween, and supplies the resultant data to the digital filter 6.

As described above, the digital filter 6 is used without modification, and a monaural signal can be oversampled at a four-time sampling rate without changing the clock frequency supplied to the A/D converter 5, the D/A converter 8 and the digital filter 6. The filter characteristics of the digital filter in this case have attenuation characteristics within the range of fₛ/2 to 7fₛ/2, as shown in fig 7A. Therefore, the low-pass filters 3, 4, 9 and 10 can have attenuation characteristics whose inclination is smaller than that of fig 2D, as indicated by a dotted line in fig 7B. In the schematic view of the digital filter, all the coefficients of F and C coefficient groups shown in fig 3 are used and are alternately set.

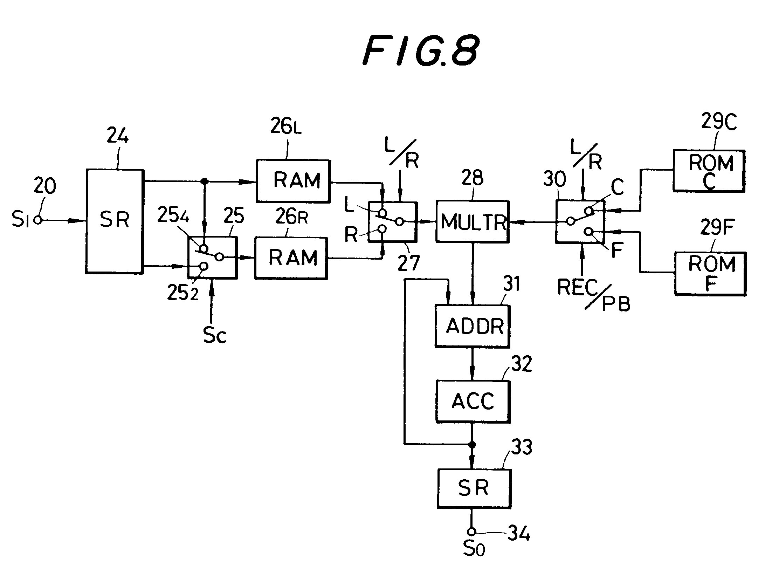

Fig 8 shows an embodiment of a digital filter for obtaining the filter characteristics shown in figs 2C and 7A.

In fig 8, reference numeral 20 denotes an input terminal receiving a digital signal S_{I} comprising 2-channel or single-channel serial data; 24, a shift register for sequentially receiving the digital signals S_{I} from the input terminal 20 and converting them into parallel data; and 25, a switch for switching a magnification of oversampling. The switch 25 is switched between a four-times rate contact 25₄ and double-rate contact 25₂ in response to a magnification switching signal S_{C}. Reference numerals 26_{L} and 26_{R} denote RAMs. When the signals S_{I} are monaural signals, the data are sequentially written in both the RAM2 26_{L} and 26_{R} in accordance with a channel switching signal L/R; 28, a multiplier for receiving output data from the switch 27 at its one input terminal; and 29_{C} and 29_{F}, ROMs storing multiplication coefficient groups, respectively. The ROM 29_{C} stores the C coefficient group and the ROM 29_{F} stores the F coefficient group. Reference numeral 30 denotes a switch for switching the outputs from the ROMs 29_{C} and 29_{F}. In the recording mode, the switch 30 is connected to a contact C to supply the C coefficient group from the ROM 29_{C} to the outer input terminal of the multiplier 28 in the L-channel A/D conversion mode. In the R-channel A/D conversion mode, the switch 30 is switched to a contact F to supply the F coefficient group form the ROM 29_{F} to the outer input terminal of the multiplier 28. In the reproducing mode, the contacts C and F of the switch 30 are switched in a manner opposite to the recording mode.

Reference numeral 31 denotes an adder for adding the multiplication output from the multiplier 28; and 32, an accumulator for latching the result from the adder 31. The output from the accumulator 32 is partially fed back to the adder 31, and is added to the multiplication output from the multiplier 28. Reference numeral 33 denotes a shift register for receiving output data from the accumulator 32 and converting it into serial data; and 34, an output terminal receiving an output signal S_{O} derived from the shift register 33.

The circuit operation of the above arrangement will be described hereinafter.

In the 2-channel signal recording mode, the switch 25 is connected to the contact 25₂. Upon reception of the L-channel signal, the switch 27 is connected to the contact L and the switch 30 is connected to the contact C, respectively. The digital signal supplied from the input terminal 20 is delayed by a predetermined amount by the shift register 24 and the RAM 26_{L}. Thereafter, the delayed signal is supplied to the multiplier 28 through the switch 27 to be sequentially multiplied with the corresponding multiplication coefficients 0, C₁, C₂, ... from the ROM 29_{C}. The multiplication output from the multiplier 28 is sequentially supplied to the adder 31, and is added to the immediately preceding multiplication output, ie, the input fed back from the accumulator 32. The addition is repetitively performed. The output from the accumulator 32 is supplied to the shift register 33, and the content of the shift register 33 is obtained from the output terminal 34 as the desired L-channel digital signal.

Upon reception of the R-channel signal, the switch 27 is switched to the contact R while the switch 30 is switched to the contact F. The digital signal from the input terminal 20 is delayed by a predetermined amount by the shift register 24, the switch 25, and the RAM 26_{R}, and is supplied to the multiplier 28 through the switch 27 to be sequentially multiplied with the corresponding multiplication coefficients F₁, F₂, ... from the ROM 29_{F}. The multiplication output from the multiplier 28 is supplied to the adder 31, and is added to the feedback input from the accumulator 32. The addition is repetitively performed. The output from the accumulator 32 is supplied to the shift register 32, and the contact of the shift register 32 is obtained from the output terminal 34 as the desired R-channel digital signal.

In the 2-channel signal reproducing mode, the switches 27 and 30 are switched in a manner opposite to that described above, and the same operation as above is performed

With the above operation, the digital filter is operated at the double sampling rate, and at this time, the filter characteristics shown in fig 2C are obtained.

When a single-channel signal S_{I} is supplied to the input terminal 20, the switch 25 is connected to the contact 25₄. In the recording and reproducing modes, the data from the shift register 24 are sequentially written in the RAMs 26_{R} and 26_{L}, and are supplied to the switch 27 which is alternately switched. The ROMS 29_{C} and 29_{F} are alternately subjected to read access, and the coefficients of the C and F coefficient groups are supplied to the multiplier 28 through the switch 30. Thus, the same operation as described above is performed, and the output signal S_{O} can be obtained from the output terminal 34.

As described above, the digital filter is operated at a four-times sampling rate, and at this time, the filter characteristics shown in fig 7A can be obtained.

Note that the single-channel signal can be one of the 2-channel signals. In this case, a digital filter having the circuit arrangement shown in fig 8 is used for the other channel signal. In this case, the 2-channel signal can be oversampled at a sampling rate of 4fₛ.

Therefore, the C and F coefficient groups defining the filter characteristics of the digital filter need only be switched in accordance with the recording/reproducing mode and the L-/R-channel signals. The phase difference between the 2-channel signals output from the digital filter can be removed in the recording mode, and the phase of one channel signal output from the digital filter to the D/A converter can be delayed from that of the other channel signal in the reproducing mode. By using the same circuit arrangement, the magnification of oversampling for the single-channel signal can be changed.

## Claims

1. A digital filter for a recording/reproducing apparatus comprising:
a single analog-to-digital converter (5) and/or a single digital-to-analog converter (8) for 2-channel signals; and
means (29C, 29F) for storing first and second multiplication coefficient groups providing predetermined filter characteristics and in interpolation relationship with each other, characterised in that the filter is operative such that
in a recording mode, the first multiplication coefficient group is used for the first channel signal, and the second multiplication coefficient group is used for the second channel signal, and
in a reproducing mode, the second multiplication coefficient group is used for the first channel signal, and the first multiplication coefficient group is used for the second channel signal.

2. A digital filter according to claim 1, wherein in recording and reproducing modes of a single-channel digital signal, the first and second multiplication coefficient groups are alternately used for each sample.

3. A digital filter according to claim 1 or 2, wherein said analog-to-digital converter (5) and/or said digital-to-analog converter oversample (8) an input signal.

4. A digital filter according to claim 3, wherein said first and second multiplication coefficient groups are alternately offset from each other at an interval corresponding to 1/2 of the oversampling period on an impulse response characteristic curve of said digital filter.

5. A digital filter according to any one of the preceding claims, further comprising first delay means (26L) arranged to receive the first channel signal, second delay means receiving the second channel signal, selection means (27) for alternately selecting the output signals from said first and second delay means (26L, 26R), and arithmetic means (28) for multiplying the output signal from said selection means (27) with coefficients of said first or second multiplication coefficient group and performing predetermined arithmetic processing.

6. A digital filter according to claim 5, wherein said first or second delay means (26L, 26R) is used for a single-channel input signal, and an output signal therefrom is supplied to said arithmetic means.

## Patentansprüche

1. Digitales Filter für ein Aufzeichnungs-/Wiedergabegerät, mit:
einem einzigen Analog-Digital-Wandler (5) und/oder einem einzigen Digital-Analog-Wandler (8) für Zweikanalsignale; und
einer Einrichtung (29C, 29F) zum Speichern einer ersten und zweiten Multiplikations-Koeffizientengruppe, die vorgegebene Filtercharakteristiken bereitstellen und in Interpolationsbeziehung zueinander stehen, dadurch gekennzeichnet, daß das Filter derart arbeitet, daß
in einem Aufzeichnungsmodus die erste Multiplikationskoeffizientengruppe für das erste Kanalsignal und die zweite Multiplikationskoeffizientengruppe für das zweite Kanalsignal verwendet wird, und
in einem Wiedergabemodus die zweite Multiplikationskoeffizientengruppe für das erste Kanalsignal und die erste Multiplikationskoeffizientengruppe für das zweite Kanalsignal verwendet wird.

2. Digitales Filter nach Anspruch 1, dadurch gekennzeichnet, daß beim Aufzeichnungs- und Wiedergabemodus eines digitalen Einkanalsignals die erste und zweite Multiplikationskoeffizientengruppe abwechselnd für jede Probe verwendet werden.

3. Digitales Filter nach Anspruch 1 oder 2, dadurch gekennzeichnet, daß der Analog-Digital-Wandler (5) und/oder der Digital-Analog-Wandler (8) ein Eingangssignal überabtasten.

4. Digitales Filter nach Anspruch 3, dadurch gekennzeichnet, daß die erste und zweite Multiplikationskoeffizientengruppe abwechselnd in einem Intervall gegeneinander versetzt sind, das der Hälfte der Überabtastungsperiode auf einer Impulsantwortkennlinie des digitalen Filters entspricht.

5. Digitales Filter nach einem der vorhergehenden Ansprüche, dadurch gekennzeichnet, daß es das weiterhin eine erste Verzögerungseinrichtung (26L) aufweist, die das erste Kanalsignal empfängt, eine zweite Verzögerungseinrichtung, die das zweite Kanalsignal empfängt, eine Auswahleinrichtung (27), um abwechselnd die Ausgangssignale von der ersten und zweiten Verzögerungseinrichtung (26L, 26R) auszuwählen, und eine Rechnereinrichtung (28) zur Multiplikation des Ausgangssignals der Auswahleinrichtung (27) mit Koefffizienten der ersten oder zweiten Multiplikationskoeffizientengruppe und zur Durchführung einer vorgegebenen Rechenoperation.

6. Digitales Filter nach Anspruch 5, dadurch gekennzeichnet, daß die erste und zweite Verzögerungseinrichtung (26L, 26R) für ein Einkanaleingangssignal verwendet werden und ein Ausgangssignal daraus an die Rechnereinrichtung gegeben wird.

## Revendications

1. Filtre numérique pour un appareil d'enregistrement et de reproduction comprenant :
un convertisseur analogique - numérique unique (5) et/ou un convertisseur numérique - analogique unique (8) pour des signaux de deux voies ; et
un dispositif (29C, 29F) pour stocker des premier et second groupes de coefficient de multiplication fournissant des caractéristiques de filtre prédéterminées et une relation d'interpolation entre eux, caractérisé en ce que le filtre est fonctionnel de sorte que
dans un mode enregistrement, le premier groupe de coefficient de multiplication est utilisé pour le premier signal de voie, et le second groupe de coefficient de multiplication est utilisé pour le second signal de voie, et
dans un mode reproduction, le second groupe de coefficient de multiplication est utilisé pour le premier signal de voie, et le premier groupe de coefficient de multiplication est utilisé pour le second signal de voie.

2. Filtre numérique selon la revendication 1, dans lequel dans des modes enregistrement et reproduction d'un signal numérique d'une voie unique, les premier et second groupes de coefficient de multiplication sont alternativement utilisés pour chaque échantillon.

3. Filtre numérique selon la revendication 1 ou 2, dans lequel ledit convertisseur analogique - numérique (5) et/ou ledit convertisseur numérique - analogique (8) sur-échantillonne un signal d'entrée.

4. Filtre numérique selon la revendication 3, dans lequel lesdits premier et second groupes de coefficient de multiplication sont alternativement décalés l'un par rapport à l'autre avec un intervalle correspondant à 1/2 période de sur-échantillonnage sur une courbe de caractéristiques de réponse à une impulsion dudit filtre numérique.

5. Filtre numérique selon l'une quelconque des revendications précédentes, comprenant en outre un premier dispositif à retard (26L) disposé pour recevoir le premier signal de voie, un second dispositif à retard pour recevoir le second signal de voie, un dispositif de sélection (27) pour sélectionner alternativement les signaux de sortie desdits premier et second dispositifs à retard (26L, 26R), et un dispositif arithmétique (28) pour multiplier le signal de sortie dudit dispositif de sélection (27) avec des coefficients dudit premier ou second groupe de coefficient de multiplication et pour réaliser un traitement arithmétique prédéterminé.

6. Filtre numérique selon la revendication 5, dans lequel on utilise ledit premier ou second dispositif à retard (26L, 26R) pour un signal d'entrée d'une voie unique, et un signal de sortie de celui-ci est appliqué audit dispositif arithmétique.
